# EUROPEAN PATENT SPECIFICATION

(11) **EP 2 924 496 B1**
(45) Date of publication and mention of the grant of the patent: **03.04.2019**
(21) Application number: 13857239.1
(22) Date of filing: 24.04.2013
(51) Int. Cl.: G02F 1/1335, H01L 27/32

(54) **DISPLAY PANEL AND PIXEL STRUCTURE**
ANZEIGETAFEL UND PIXELSTRUKTUR
PANNEAU D'AFFICHAGE ET STRUCTURE DE PIXELS

(30) Priority: 26.11.2012 CN 201210486326
(43) Date of publication of application: 30.09.2015
(73) Proprietor: TCL Corporation, Guangdong 516006 (CN)
(72) Inventor: SHAO, Shiqiang, Shenzhen, Guangdong 518052 (CN); YAN, Xiaolin, Shenzhen, Guangdong 518052 (CN); GAO, Zhuo, Shenzhen, Guangdong 518052 (CN); WU, Meifen, Shenzhen, Guangdong 518052 (CN); FU, Dong, Shenzhen, Guangdong 518052 (CN)
(74) Representative: Kuhnen & Wacker Patent- und Rechtsanwaltsbüro PartG mbB
(86) International application number: PCT/CN2013/074583
(87) International publication number: WO 2014/079197

(56) References cited:
- CN-A- 101 075 608
- CN-A- 101 118 340
- CN-A- 101 364 005
- CN-U- 202 904 169
- JP-B2- 3 292 133
- US-A1- 2011 012 011

## Description

### BACKGROUND OF THE INVENTION

### 1. Technical Field

The present invention relates to the field of color display, in particular, to a display panel and a pixel structure.

### 2. Description of Related Art

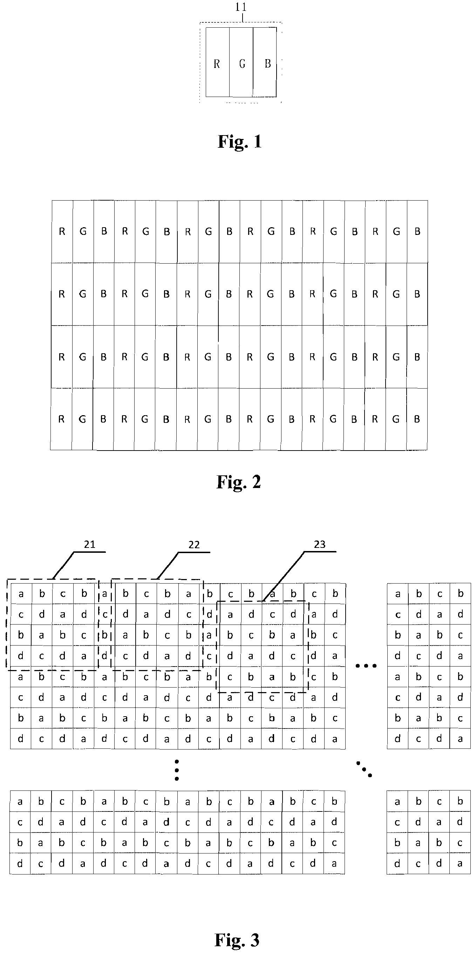

A color filter array (CFA) is a key factor affecting resolution and color representation of a display, three primary colors of a sub-pixel of the color filter array of the prior liquid crystal display and white light OLED display mostly are red, green and blue, a pixel structure is formed by a vertical arrangement of a red sub-pixel, a green sub-pixel and a blue sub-pixel, then a display is formed by a repeated arrangement of a number of the same sub-pixels. Fig. 1 illustrates a pixel structure 11, the pixel structure 11 includes a red (R) sub-pixel, a green (G) sub-pixel and a blue (B) sub-pixel, a display formed by a repeated arrangement of the pixel structures 11 can display all kinds of colored pictures, as shown in fig. 2.

The same sub-pixels of a display screen formed by the above-mentioned vertical arrangement of the sub-pixels are continuously arranged in a vertical direction, however, the same sub-pixels are spaced by two sub-pixels in a horizontal direction. It can be seen that, by using Fourier spectral analysis, a spectrum aliasing is generated in a horizontal axis of a spectrum of the arrangement, which deteriorates display quality.

With the development of display technology, people put forward higher requirement for visual effects, resulting in the requirement of higher resolution and better color representation. However, both of the prior pixel structure and display screen have shortcomings.

Therefore, the existing techniques need to be improved.

### BRIEF SUMMARY OF THE INVENTION

The object of the present invention is to provide a display panel and a pixel structure which has a higher resolution and better color representation than the existing techniques.

The present invention adopts the following technical solutions:
A display panel, wherein the display panel is formed by a repeated arrangement of a plurality of display units, each of the plurality of display units consisting of a 4×4 array or 2×8 array;
sub-pixels of the first row of the display unit formed by the 4×4 array are, in order, sub-pixel a, sub-pixel b, sub-pixel c and sub-pixel b from left to right; sub-pixels of the second row of the display unit formed by the 4×4 array are, in order, sub-pixel c, sub-pixel d, sub-pixel a and sub-pixel d from left to right; sub-pixels of the third row of the display unit formed by the 4×4 array are, in order, sub-pixel b, sub-pixel a, sub-pixel b and sub-pixel c from left to right; sub-pixels of the fourth row of the display unit formed by the 4×4 array are, in order, sub-pixel d, sub-pixel c, sub-pixel d and sub-pixel a from left to right;
an arrangement structure of sub-pixels of the display unit formed by the 2×8 array is selected from one of the following combinations:
   sub-pixels of the first row are, in order, sub-pixel a, sub-pixel b, sub-pixel a, sub-pixel d, sub-pixel c, sub-pixel b, sub-pixel c and sub-pixel d from left to right; sub-pixels of the second row are, in order, sub-pixel c, sub-pixel d, sub-pixel c, sub-pixel b, sub-pixel a, sub-pixel d, sub-pixel a and sub-pixel b from left to right;
   sub-pixels of the first row are, in order, sub-pixel b, sub-pixel a, sub-pixel b, sub-pixel a, sub-pixel d, sub-pixel c, sub-pixel d, and sub-pixel c from left to right; sub-pixels of the second row are, in order, sub-pixel d, sub-pixel c, sub-pixel d, sub-pixel c, sub-pixel b, sub-pixel a, sub-pixel b and sub-pixel a from left to right;
   sub-pixels of the first row are, in order, sub-pixel b, sub-pixel a, sub-pixel b, sub-pixel a, sub-pixel b, sub-pixel c, sub-pixel b and sub-pixel c from left to right; sub-pixels of the second row are, in order, sub-pixel d, sub-pixel c, sub-pixel d, sub-pixel c, sub-pixel d, sub-pixel a, sub-pixel d and sub-pixel a from left to right;
   colors of the sub-pixels a, b, c and d are different from each other,
   wherein the color of each of the sub-pixels a and c is red or blue, the color of each of the sub-pixels b and d is green or white.

According to the display panel, the arrangement structure of sub-pixels of the display unit formed by the 4×4 array is one of the following combinations:
sub-pixels of the first row are, in order, R sub-pixel, G sub-pixel, B sub-pixel and G sub-pixel from left to right; sub-pixels of the second row are, in order, B sub-pixel, W sub-pixel, R sub-pixel and W sub-pixel from left to right; sub-pixels of the third row are, in order, G sub-pixel, R sub-pixel, G sub-pixel and B sub-pixel from left to right; sub-pixels of the fourth row are, in order, W sub-pixel, B sub-pixel, W sub-pixel and R sub-pixel from left to right;
sub-pixels of the first row are, in order, R sub-pixel, W sub-pixel, B sub-pixel and W sub-pixel from left to right; sub-pixels of the second row are, in order, B sub-pixel, G sub-pixel, R sub-pixel and G sub-pixel from left to right; sub-pixels of the third row are, in order, W sub-pixel, R sub-pixel, W sub-pixel and B sub-pixel from left to right; sub-pixels of the fourth row are, in order, G sub-pixel, B sub-pixel, G sub-pixel and R sub-pixel from left to right;
sub-pixels of the first row are, in order, B sub-pixel, G sub-pixel, R sub-pixel and G sub-pixel from left to right; sub-pixels of the second row are, in order, R sub-pixel, W sub-pixel, B sub-pixel and W sub-pixel from left to right; sub-pixels of the third row are, in order, G sub-pixel, B sub-pixel, G sub-pixel and R sub-pixel from left to right; sub-pixels of the fourth row are, in order, W sub-pixel, R sub-pixel, W sub-pixel and B sub-pixel from left to right;
sub-pixels of the first row are, in order, B sub-pixel, W sub-pixel, R sub-pixel and W sub-pixel from left to right; sub-pixels of the second row are, in order, R sub-pixel, G sub-pixel, B sub-pixel and G sub-pixel from left to right; sub-pixels of the third row are, in order, W sub-pixel, B sub-pixel, W sub-pixel and R sub-pixel from left to right; sub-pixels of the fourth row are, in order, G sub-pixel, R sub-pixel, G sub-pixel and B sub-pixel from left to right;
the arrangement structure of sub-pixels of the display unit formed by the 2×8 array is one of the following combinations:
   sub-pixels of the first row are, in order, R sub-pixel, G sub-pixel, R sub-pixel, W sub-pixel, B sub-pixel, G sub-pixel, B sub-pixel and W sub-pixel from left to right; sub-pixels of the second row are, in order, B sub-pixel, W sub-pixel, B sub-pixel, G sub-pixel, R sub-pixel, W sub-pixel, R sub-pixel and G sub-pixel from left to right;
   sub-pixels of the first row are, in order, B sub-pixel, G sub-pixel, B sub-pixel, W sub-pixel, R sub-pixel, G sub-pixel, R sub-pixel and W sub-pixel from left to right; sub-pixels of the second row are, in order, R sub-pixel, W sub-pixel, R sub-pixel, G sub-pixel, B sub-pixel, W sub-pixel, B sub-pixel and G sub-pixel from left to right;
   sub-pixels of the first row are, in order, R sub-pixel, W sub-pixel, R sub-pixel, G sub-pixel, B sub-pixel, W sub-pixel, B sub-pixel and G sub-pixel from left to right; sub-pixels of the second row are, in order, B sub-pixel, G sub-pixel, B sub-pixel, W sub-pixel, R sub-pixel, G sub-pixel, R sub-pixel and W sub-pixel from left to right;
   sub-pixels of the first row are, in order, B sub-pixel, W sub-pixel, B sub-pixel, G sub-pixel, R sub-pixel, W sub-pixel, R sub-pixel and G sub-pixel from left to right; sub-pixels of the second row are, in order, R sub-pixel, G sub-pixel, R sub-pixel, W sub-pixel, B sub-pixel, G sub-pixel, B sub-pixel and W sub-pixel from left to right;
   sub-pixels of the first row are, in order, G sub-pixel, R sub-pixel, G sub-pixel, R sub-pixel, W sub-pixel, B sub-pixel, W sub-pixel and B sub-pixel from left to right; sub-pixels of the second row are, in order, W sub-pixel, B sub-pixel, W sub-pixel, B sub-pixel, G sub-pixel, R sub-pixel, G sub-pixel and R sub-pixel from left to right;
   sub-pixels of the first row are, in order, G sub-pixel, B sub-pixel, G sub-pixel, B sub-pixel, W sub-pixel, R sub-pixel, W sub-pixel and R sub-pixel from left to right; sub-pixels of the second row are, in order, W sub-pixel, R sub-pixel, W sub-pixel, R sub-pixel, G sub-pixel, B sub-pixel, G sub-pixel and B sub-pixel from left to right;
   sub-pixels of the first row are, in order, W sub-pixel, R sub-pixel, W sub-pixel, R sub-pixel, G sub-pixel, B sub-pixel, G sub-pixel and B sub-pixel from left to right; sub-pixels of the second row are, in order, G sub-pixel, B sub-pixel, G sub-pixel, B sub-pixel, W sub-pixel, R sub-pixel, W sub-pixel and R sub-pixel from left to right;
   sub-pixels of the first row are, in order, W sub-pixel, B sub-pixel, W sub-pixel, B sub-pixel, G sub-pixel, R sub-pixel, G sub-pixel and R sub-pixel from left to right; sub-pixels of the second row are, in order, G sub-pixel, R sub-pixel, G sub-pixel, R sub-pixel, W sub-pixel, B sub-pixel, W sub-pixel and B sub-pixel from left to right;
   sub-pixels of the first row are, in order, G sub-pixel, R sub-pixel, G sub-pixel, R sub-pixel, G sub-pixel, B sub-pixel, G sub-pixel and B sub-pixel from left to right; sub-pixels of the second row are, in order, W sub-pixel, B sub-pixel, W sub-pixel, B sub-pixel, W sub-pixel, R sub-pixel, W sub-pixel and R sub-pixel from left to right;
   sub-pixels of the first row are, in order, G sub-pixel, B sub-pixel, G sub-pixel, B sub-pixel, G sub-pixel, R sub-pixel, G sub-pixel and R sub-pixel from left to right; sub-pixels of the second row are, in order, W sub-pixel, R sub-pixel, W sub-pixel, R sub-pixel, W sub-pixel, B sub-pixel, W sub-pixel and B sub-pixel from left to right;
   sub-pixels of the first row are, in order, W sub-pixel, R sub-pixel, W sub-pixel, R sub-pixel, W sub-pixel, B sub-pixel, W sub-pixel and B sub-pixel from left to right; sub-pixels of the second row are, in order, G sub-pixel, B sub-pixel, G sub-pixel, B sub-pixel, G sub-pixel, R sub-pixel, G sub-pixel and R sub-pixel from left to right;
   sub-pixels of the first row are, in order, W sub-pixel, B sub-pixel, W sub-pixel, B sub-pixel, W sub-pixel, R sub-pixel, W sub-pixel and R sub-pixel from left to right; sub-pixels of the second row are, in order, G sub-pixel, R sub-pixel, G sub-pixel, R sub-pixel, G sub-pixel, B sub-pixel, G sub-pixel and B sub-pixel from left to right;
   wherein R, G, B and W sub-pixels are a red sub-pixel, a green sub-pixel, a blue sub-pixel and a white sub-pixel, respectively.

According to the display panel, a sub-pixel unit aa can be formed by adjacent two sub-pixels a, a sub-pixel unit cc can be formed by adjacent two sub-pixels c, sub-pixels in every sub-pixel unit aa are controlled by one aa sub-pixel drive circuit, sub-pixels in every sub-pixel unit cc are controlled by one cc sub-pixel drive circuit.

According to the display panel, an aspect ratio of each of the sub-pixels a, b, c and d is 1:2 when the display unit is the 2×8 sub-pixel array.

According to the display panel, an aspect ratio of each of the sub-pixels a, b, c and d is 1:1 when the display unit is the 4×4 sub-pixel array.

The display panel is formed by a repeated arrangement of the rotated, transposed or reversed display units.

A pixel structure, wherein the pixel structure is the sub-pixel array in any continuous 4×4 arrays in the display panel formed by the 4×4 arrays according to claim 1 or the sub-pixel array in any continuous 2×8 arrays in the display panel formed by the 2×8 arrays according to claim 1.

According to the pixel structure, sub-pixels of the first row of the pixel structure are, in order, sub-pixel a, sub-pixel b, sub-pixel c and sub-pixel b from left to right; sub-pixels of the second row of the pixel structure are, in order, sub-pixel c, sub-pixel d, sub-pixel a and sub-pixel d from left to right; sub-pixels of the third row of the pixel structure are, in order, sub-pixel b, sub-pixel a, sub-pixel b and sub-pixel c from left to right; sub-pixels of the fourth row of the pixel structure are, in order, sub-pixel d, sub-pixel c, sub-pixel d and sub-pixel a from left to right when the pixel structure is the 4×4 sub-pixel array.

The pixel structure is selected from one of the following combinations when the pixel structure is the 2×8 sub-pixel array:
sub-pixels of the first row are, in order, sub-pixel a, sub-pixel b, sub-pixel a, sub-pixel d, sub-pixel c, sub-pixel b, sub-pixel c and sub-pixel d from left to right; sub-pixels of the second row are, in order, sub-pixel c, sub-pixel d, sub-pixel c, sub-pixel b, sub-pixel a, sub-pixel d, sub-pixel a and sub-pixel b from left to right;
sub-pixels of the first row are, in order, sub-pixel b, sub-pixel a, sub-pixel b, sub-pixel a, sub-pixel d, sub-pixel c, sub-pixel d, and sub-pixel c from left to right; sub-pixels of the second row are, in order, sub-pixel d, sub-pixel c, sub-pixel d, sub-pixel c, sub-pixel b, sub-pixel a, sub-pixel b and sub-pixel a from left to right;
sub-pixels of the first row are, in order, sub-pixel b, sub-pixel a, sub-pixel b, sub-pixel a, sub-pixel b, sub-pixel c, sub-pixel b and sub-pixel c from left to right; sub-pixels of the second row are, in order, sub-pixel d, sub-pixel c, sub-pixel d, sub-pixel c, sub-pixel d, sub-pixel a, sub-pixel d and sub-pixel a from left to right;

The present invention has the following advantages: the present invention improves the uniformity of the spatial sampling by optimizing the arrangement structure of the sub-pixel array in the display panel and the pixel structure, so that the resolution of the display panel can be improved. Furthermore, the brightness of the display panel is improved with reduced power loss by the addition of the white sub-pixel. In addition, the sub-pixel unit aa or cc is controlled by the same drive circuit, the power loss is further reduced, and the average aperture ratio of the display panel is improved.

### BRIEF DESCRIPTION OF THE SEVERAL VIEWS OF THE DRAWINGS

Fig. 1 is a schematic structure diagram of the prior pixel structure;
Fig. 2 is a schematic structure diagram of a display panel formed by the pixel structure as shown in fig. 1;
Fig. 3 is a schematic structure diagram of a display panel according to a first embodiment of the present invention;
Fig. 4 is a schematic structure diagram of sub-pixel units aa and cc in the display panel as shown in fig. 3;
Fig. 5 is a spectrum of the display panel as shown in fig. 2;
Fig. 6 is a spectrum of the display panel as shown in fig. 3;
Fig. 7 is a schematic structure diagram of a display panel according to a second embodiment of the present invention;
Fig. 8 is a schematic structure diagram of a display panel according to a third embodiment of the present invention; and
Fig. 9 is a schematic structure diagram of a display panel according to a fourth embodiment of the present invention;

### DETAILED DESCRIPTION OF THE INVENTION

The present invention provides a display panel and a pixel structure, in order to make clearer the objects, technical solutions and advantages of the invention, the present invention will be explained below in detail. It is to be understood that the following description of the embodiments is merely to explain the present invention and is no way intended to limit the invention.

According to the display panel provided by the present invention, the display panel is formed by a repeated arrangement of a plurality of display units, the display unit consists of a 4×4 array or 2×8 array.

The present invention will be explained below in detail with reference to the accompanying drawings.

Referring to fig. 3, the display unit 21 consists of a 4×4 array. In the display unit 21, sub-pixels of the first row are, in order, sub-pixel a, sub-pixel b, sub-pixel c and sub-pixel b from left to right; sub-pixels of the second row are, in order, sub-pixel c, sub-pixel d, sub-pixel a and sub-pixel d from left to right; sub-pixels of the third row are, in order, sub-pixel b, sub-pixel a, sub-pixel b and sub-pixel c from left to right; sub-pixels of the fourth row are, in order, sub-pixel d, sub-pixel c, sub-pixel d and sub-pixel a from left to right.

The colors of the sub-pixels a, b, c and d in the display unit 21 are different from each other.

For the display panel formed by the display units 21, since each sub-pixel is distributed more uniformly, the sampling interval is appropriately increased, the difference between the sampling frequencies is reduced in the vertical and horizontal direction, thereby making a more balanced sampling.

According to the embodiment, the color of each of the sub-pixels a, b, c and d is one of red, green, blue and white, i.e. compared with the traditional display panel, a white sub-pixel is added, therefore, the brightness of the display panel is improved, the power loss of the display panel also is reduced.

More preferably, the color of each of the sub-pixels a and c is red or blue, the color of each of the sub-pixels b and d is green or white. In other words, the sub-pixel a is a red sub-pixel and the sub-pixel c is a blue sub-pixel, or the sub-pixel a is a blue sub-pixel and the sub-pixel c is a red sub-pixel. The sub-pixel b is a green sub-pixel and the sub-pixel d is a white sub-pixel, or the sub-pixel b is a white sub-pixel and the sub-pixel d is a green sub-pixel.

Therefore, the arrangement structure of the display unit 21 formed by the 4×4 array is: sub-pixels of the first row are, in order, R sub-pixel, G sub-pixel, B sub-pixel and G sub-pixel from left to right; sub-pixels of the second row are, in order, B sub-pixel, W sub-pixel, R sub-pixel and W sub-pixel from left to right; sub-pixels of the third row are, in order, G sub-pixel, R sub-pixel, G sub-pixel and B sub-pixel from left to right; sub-pixels of the fourth row are, in order, W sub-pixel, B sub-pixel, W sub-pixel and R sub-pixel from left to right.

The arrangement structure of the display unit also can be the following structure: sub-pixels of the first row are, in order, R sub-pixel, W sub-pixel, B sub-pixel and W sub-pixel from left to right; sub-pixels of the second row are, in order, B sub-pixel, G sub-pixel, R sub-pixel and G sub-pixel from left to right; sub-pixels of the third row are, in order, W sub-pixel, R sub-pixel, W sub-pixel and B sub-pixel from left to right; sub-pixels of the fourth row are, in order, G sub-pixel, B sub-pixel, G sub-pixel and R sub-pixel from left to right.

The arrangement structure of the display unit also can be the following structure: sub-pixels of the first row are, in order, B sub-pixel, G sub-pixel, R sub-pixel and G sub-pixel from left to right; sub-pixels of the second row are, in order, R sub-pixel, W sub-pixel, B sub-pixel and W sub-pixel from left to right; sub-pixels of the third row are, in order, G sub-pixel, B sub-pixel, G sub-pixel and R sub-pixel from left to right; sub-pixels of the fourth row are, in order, W sub-pixel, R sub-pixel, W sub-pixel and B sub-pixel from left to right.

The arrangement structure of the display unit also can be the following structure: sub-pixels of the first row are, in order, B sub-pixel, W sub-pixel, R sub-pixel and W sub-pixel from left to right; sub-pixels of the second row are, in order, R sub-pixel, G sub-pixel, B sub-pixel and G sub-pixel from left to right; sub-pixels of the third row are, in order, W sub-pixel, B sub-pixel, W sub-pixel and R sub-pixel from left to right; sub-pixels of the fourth row are, in order, G sub-pixel, R sub-pixel, G sub-pixel and B sub-pixel from left to right. In the above arrangement structure of the display unit, R sub-pixel, G sub-pixel, B sub-pixel and W sub-pixel are a red sub-pixel, a green sub-pixel, a blue sub-pixel and a white sub-pixel.

In the display panel as shown in fig. 3, sub-pixels b and d are uniformly arranged, for example, there are six sub-pixels b adjacent to one sub-pixel b, the six sub-pixels b are uniformly arranged about the centrally located sub-pixel b, thereby forming a structure similar to a regular hexagon. Thus, the sub-pixels b in the display panel can be arranged very uniformly, the spatial arrangement of the sub-pixels b are isotropic, the spatial sampling of the sub-pixels b also become more uniform, the spatial sampling of the sub-pixels d also become more uniform since the spatial arrangement of the sub-pixels d are similar to that of the sub-pixels b. If the color of each of the sub-pixels b and d is green or white, the resolution of the display panel will be improved, for the reason that the human eye is more sensitive to white and green than blue and red on spatial resolution, contribution of the white sub-pixel and the green sub-pixel to the brightness of display panel is further greater than the contribution of the red sub-pixel and the blue sub-pixel. Especially, if a pixel is small enough, the human eye is more sensitive to the brightness of a single pixel than the chrominance thereof, therefore, the resolution of the display panel can be improved greatly if the spatial arrangement of the white sub-pixels and the green sub-pixels is more uniform, the sub-pixels b and d are preferably arranged more uniformly in the present invention. In addition, since contribution of the sub-pixels a and c to the brightness is small, the spatial arrangement of the sub-pixels a and c doesn't make pictures distorted, the influences of the spatial arrangement on the resolution don't attract visual attention, thereby ensuring a high resolution of the display panel.

It is to be noted that, the display panel is not limited to be only formed by the repeated arrangement of the display units 21, the display panel can be formed by any continuous 4×4 sub-pixel arrays in fig. 3, such as display units 22 or display units 23 selected from fig. 3. Also, the effects of more uniform spatial sampling of the present invention can be achieved. Furthermore, the display panel of the present invention isn't limited to the embodiment shown in fig. 1, the effects of more uniform spatial sampling also can be achieved if the display panel is formed by rotating, transposing or reversing the arrangement structure of the sub-pixels in the display panel shown in fig. 3.

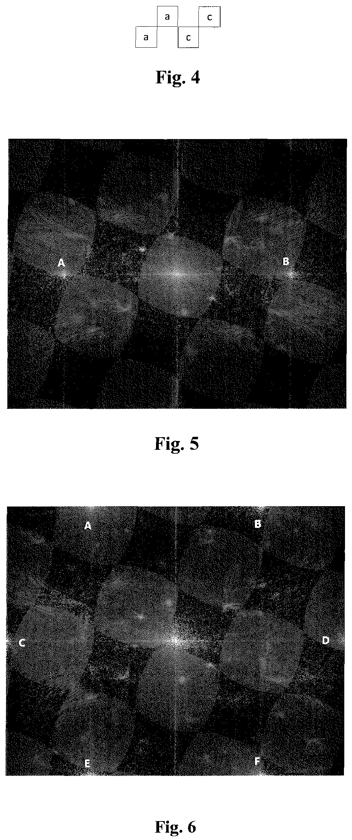

It can be seen from fig. 3 that except for sub-pixels on edges of the display panel, each of the sub-pixels a in the display panel is surrounded by eight adjacent sub-pixels. There is one sub-pixel in the eight adjacent sub-pixels, i.e. sub-pixel a, whose color is the same with the color of the surrounded sub-pixel. Thus, a sub-pixel unit aa is formed by the two adjacent sub-pixels a, similarly, a sub-pixel unit cc is formed by two adjacent sub-pixels c, as shown in fig. 4. The resolution of the existing display panel becomes higher and higher, however, the human eye is more sensitive to white and green than blue and red when physical size of a pixel is very small, such as the case in which the pixel density reaches up to 300Dpi. Therefore, in the present invention the two sub-pixels a in the sub-pixel unit aa are preferably controlled by one drive circuit which is called as "aa sub-pixel unit drive circuit", the two sub-pixels c in the sub-pixel unit cc are also preferably controlled by one drive circuit which is called as "cc sub-pixel unit drive circuit". Those changes make minimal influences on the resolution and can't be noticed by the human eye. Additionally, since the number of drive circuits is reduced, not only is the space occupied by drive circuits reduced, which increases the average aperture ratio of the display panel, but also the power loss is further reduced, which is very important for the display panel with a high resolution.

The following will describe the spectrums of the display panel illustrated in fig. 3 and the prior display panel illustrated in fig. 2 in a compare fashion. Fig. 5 illustrates the spectrum of the display panel shown in fig. 2, spectrums in fig. 5 are relatively focused on points A and B which are called as focus points. Combining the sub-pixel arrangement of the display panel in fig. 2, it isn't difficult to know that the focus points A and B are caused by spaced sampling of sub-pixels with the same color, for example, red sub-pixels in fig. 2 are continuous sampled in a vertical direction, however, the red sub-pixels are sampled at intervals in a horizontal direction, thereby making the sampling spectrums of the red sub-pixels different in the vertical and horizontal directions. However, since objects are isotropic when people see the objects, i.e. there is not difference in the vertical and horizontal directions when people see the objects, and the distribution of the focus points of the spectrum in the fig. 5 is not isotropic, the sub-pixel arrangement of the prior display panel is not optimal.

There are six focus points A, B, C, D, E and F in the spectrum shown in fig. 6, the six focus points are arranged in an approximately circular fashion, the circular arrangement is close to an isotropic arrangement, therefore, the circular arrangement is in accord with visual characteristics of the human eye, and the resolution of the display panel shown in fig. 3 is better than that of the prior display panel.

Except for the embodiment disclosed by fig. 3, the present invention can be implemented by other embodiments. In those embodiments, the arrangement of the sub-pixels b and d can be made to be isotropic in order to improve the resolution of the display panel.

The following will describe those embodiments in detail with reference to the accompanying drawings.

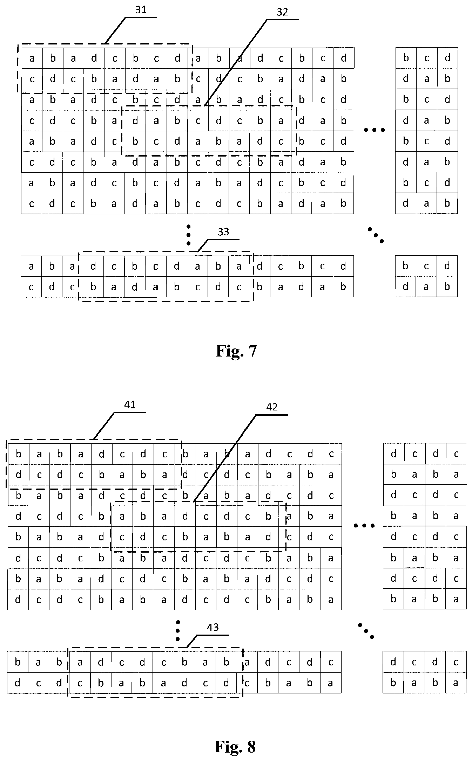

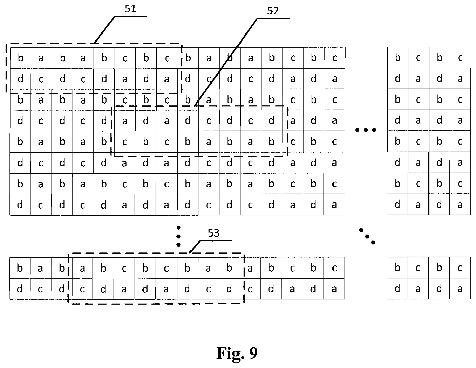

An arrangement structure of sub-pixels of the display unit formed by the 2×8 array is selected from one of the following combinations:
As shown in fig. 7, sub-pixels of the first row of display unit 31 are, in order, sub-pixel a, sub-pixel b, sub-pixel a, sub-pixel d, sub-pixel c, sub-pixel b, sub-pixel c and sub-pixel d from left to right; sub-pixels of the second row are, in order, sub-pixel c, sub-pixel d, sub-pixel c, sub-pixel b, sub-pixel a, sub-pixel d, sub-pixel a and sub-pixel b from left to right;
As shown in fig. 8, sub-pixels of the first row of display unit 41, in order, sub-pixel b, sub-pixel a, sub-pixel b, sub-pixel a, sub-pixel d, sub-pixel c, sub-pixel d, and sub-pixel c from left to right; sub-pixels of the second row are, in order, sub-pixel d, sub-pixel c, sub-pixel d, sub-pixel c, sub-pixel b, sub-pixel a, sub-pixel b and sub-pixel a from left to right;
As shown in fig. 9, sub-pixels of the first row of display unit 51, in order, sub-pixel b, sub-pixel a, sub-pixel b, sub-pixel a, sub-pixel b, sub-pixel c, sub-pixel b, and sub-pixel c from left to right; sub-pixels of the second row are, in order, sub-pixel d, sub-pixel c, sub-pixel d, sub-pixel c, sub-pixel d, sub-pixel a, sub-pixel d and sub-pixel a from left to right;
In the above three embodiments of the 2×8 array, the color of each of the sub-pixels a, b, c and d is one of red, green, blue and white, and the colors of the sub-pixels a, b, c and d are different from each other.

More preferably, the color of each of the sub-pixels a and c is red or bluer, the color of each of the sub-pixels b and d is green or white. In other words, the sub-pixel a is a red sub-pixel and the sub-pixel c is a blue sub-pixel, or the sub-pixel a is a blue sub-pixel and the sub-pixel c is a red sub-pixel. The sub-pixel b is a green sub-pixel and the sub-pixel d is a white sub-pixel, or the sub-pixel b is a white sub-pixel and the sub-pixel d is a green sub-pixel. The reasons for the arrangements can refer to the following description.

The arrangement structure of the sub-pixels according to display unit 31 shown in fig. 7 can be one of the following combinations:
sub-pixels of the first row are, in order, R sub-pixel, G sub-pixel, R sub-pixel, W sub-pixel, B sub-pixel, G sub-pixel, B sub-pixel and W sub-pixel from left to right; sub-pixels of the second row are, in order, B sub-pixel, W sub-pixel, B sub-pixel, G sub-pixel, R sub-pixel, W sub-pixel, R sub-pixel and G sub-pixel from left to right;
sub-pixels of the first row are, in order, B sub-pixel, G sub-pixel, B sub-pixel, W sub-pixel, R sub-pixel, G sub-pixel, R sub-pixel and W sub-pixel from left to right; sub-pixels of the second row are, in order, R sub-pixel, W sub-pixel, R sub-pixel, G sub-pixel, B sub-pixel, W sub-pixel, B sub-pixel and G sub-pixel from left to right;
sub-pixels of the first row are, in order, R sub-pixel, W sub-pixel, R sub-pixel, G sub-pixel, B sub-pixel, W sub-pixel, B sub-pixel and G sub-pixel from left to right; sub-pixels of the second row are, in order, B sub-pixel, G sub-pixel, B sub-pixel, W sub-pixel, R sub-pixel, G sub-pixel, R sub-pixel and W sub-pixel from left to right;
sub-pixels of the first row are, in order, B sub-pixel, W sub-pixel, B sub-pixel, G sub-pixel, R sub-pixel, W sub-pixel, R sub-pixel and G sub-pixel from left to right; sub-pixels of the second row are, in order, R sub-pixel, G sub-pixel, R sub-pixel, W sub-pixel, B sub-pixel, G sub-pixel, B sub-pixel and W sub-pixel from left to right.

The arrangement structure of the sub-pixels according to display unit 41 shown in fig. 8 can be one of the following combinations:
sub-pixels of the first row are, in order, G sub-pixel, R sub-pixel, G sub-pixel, R sub-pixel, W sub-pixel, B sub-pixel, W sub-pixel and B sub-pixel from left to right; sub-pixels of the second row are, in order, W sub-pixel, B sub-pixel, W sub-pixel, B sub-pixel, G sub-pixel, R sub-pixel, G sub-pixel and R sub-pixel from left to right;
sub-pixels of the first row are, in order, G sub-pixel, B sub-pixel, G sub-pixel, B sub-pixel, W sub-pixel, R sub-pixel, W sub-pixel and R sub-pixel from left to right; sub-pixels of the second row are, in order, W sub-pixel, R sub-pixel, W sub-pixel, R sub-pixel, G sub-pixel, B sub-pixel, G sub-pixel and B sub-pixel from left to right;
sub-pixels of the first row are, in order, W sub-pixel, R sub-pixel, W sub-pixel, R sub-pixel, G sub-pixel, B sub-pixel, G sub-pixel and B sub-pixel from left to right; sub-pixels of the second row are, in order, G sub-pixel, B sub-pixel, G sub-pixel, B sub-pixel, W sub-pixel, R sub-pixel, W sub-pixel and R sub-pixel from left to right;
sub-pixels of the first row are, in order, W sub-pixel, B sub-pixel, W sub-pixel, B sub-pixel, G sub-pixel, R sub-pixel, G sub-pixel and R sub-pixel from left to right; sub-pixels of the second row are, in order, G sub-pixel, R sub-pixel, G sub-pixel, R sub-pixel, W sub-pixel, B sub-pixel, W sub-pixel and B sub-pixel from left to right.

The arrangement structure of the sub-pixels according to display unit 51 shown in fig. 9 can be one of the following combinations:
sub-pixels of the first row are, in order, G sub-pixel, R sub-pixel, G sub-pixel, R sub-pixel, G sub-pixel, B sub-pixel, G sub-pixel and B sub-pixel from left to right; sub-pixels of the second row are, in order, W sub-pixel, B sub-pixel, W sub-pixel, B sub-pixel, W sub-pixel, R sub-pixel, W sub-pixel and R sub-pixel from left to right;
sub-pixels of the first row are, in order, G sub-pixel, B sub-pixel, G sub-pixel, B sub-pixel, G sub-pixel, R sub-pixel, G sub-pixel and R sub-pixel from left to right; sub-pixels of the second row are, in order, W sub-pixel, R sub-pixel, W sub-pixel, R sub-pixel, W sub-pixel, B sub-pixel, W sub-pixel and B sub-pixel from left to right;
sub-pixels of the first row are, in order, W sub-pixel, R sub-pixel, W sub-pixel, R sub-pixel, W sub-pixel, B sub-pixel, W sub-pixel and B sub-pixel from left to right; sub-pixels of the second row are, in order, G sub-pixel, B sub-pixel, G sub-pixel, B sub-pixel, G sub-pixel, R sub-pixel, G sub-pixel and R sub-pixel from left to right;
sub-pixels of the first row are, in order, W sub-pixel, B sub-pixel, W sub-pixel, B sub-pixel, W sub-pixel, R sub-pixel, W sub-pixel and R sub-pixel from left to right; sub-pixels of the second row are, in order, G sub-pixel, R sub-pixel, G sub-pixel, R sub-pixel, G sub-pixel, B sub-pixel, G sub-pixel and B sub-pixel from left to right. In the above display unit, R sub-pixel, G sub-pixel, B sub-pixel and W sub-pixel are a red sub-pixel, a green sub-pixel, a blue sub-pixel and a white sub-pixel, respectively.

Taking the display panel shown in fig. 7 as an example, each of the sub-pixels b is located at a central position, there are six sub-pixels b which are the closest to the central position, the arrangement of the six sub-pixels b is close to a regular hexagon. Thus, the spatial arrangement of the sub-pixels b tends to be isotropic, and the spatial arrangement of the sub-pixels d also tends to be isotropic. Thus, the spatial sampling of the white sub-pixels and the green sub-pixels becomes more uniform, which is helpful to improve the resolution of the display panel. However, the spatial arrangement of the sub-pixels a and c is not in strict accordance with the above regulations, specific reasons have been described above, and aren't explained here.

Furthermore, the display panel in fig. 7 isn't limited to be formed by the repeated arrangement of the display unit 31, the display panel in fig. 7 also can be formed by any continuous 2×8 sub-pixel arrays selected from fig. 7, such as the display units 32 or display units 33 shown in the figure. In addition, also, the effects of more uniform spatial sampling can be achieved and the resolution can be improved when the display panel is formed by rotating, transposing or reversing the arrangement structure of the sub-pixels in the display panel shown in fig. 7.

The display panels shown in fig. 8 and fig. 9 are similar to the display panel shown in fig. 7. The sub-pixels b according to the embodiments shown in fig. 8 and fig. 9 aren't arranged to form the regular hexagon, however, the arrangement of the sub-pixel arrays also can make the spatial arrangement of the sub-pixels b tend to be isotropic. Similarly, the spatial arrangement of the sub-pixels d also tends to be isotropic. The spatial arrangement of the sub-pixels a and c is not in strict accordance with isotropy, specific reasons have been described above, and aren't explained here. The display panel in the embodiment shown in fig. 8 isn't limited to be formed by the display unit 41, the display panel also can be formed by the repeated arrangement of any continuous 2×8 sub-pixel arrays selected from fig. 8, such as the display units 42 or display units 43 shown in the figure. The display panel in the embodiment shown in fig. 9 also can be formed by the repeated arrangement of any continuous 2×8 sub-pixel arrays selected from fig. 9, such as the display units 52 or display units 53.

In the display unit (the 4×4 sub-pixel array or the 2×8 sub-pixel array), the sub-pixels a, b, c and d have an aspect ratio of 1:2 (aspect ratios of the sub-pixels in the accompanying drawings are illustrated for convenience only, the aspect ratios don't represent real aspect ratios), respectively. Especially, when each of the sub-pixels in the embodiments shown in fig. 7 and fig. 8 has an aspect ratio of 1:2, the spatial arrangements of sub-pixels b and d can further tend to be isotropic, the resolution can be further improved.

Based on the above display panel, the present invention also provides a pixel structure, the pixel structure is the sub-pixel array in any continuous 4×4 arrays in the display panel formed by the 4×4 arrays or the sub-pixel array in any continuous 2×8 arrays in the display panel formed by the 2×8 arrays. In other words, the display panel can be formed by the repeated arrangement of the above pixel structures.

Particularly, the pixel structure can be the display unit shown in fig. 3, i.e. the 4×4 sub-pixel array, sub-pixels of the first row of the pixel structure are, in order, sub-pixel a, sub-pixel b, sub-pixel c and sub-pixel b from left to right; sub-pixels of the second row of the pixel structure are, in order, sub-pixel c, sub-pixel d, sub-pixel a and sub-pixel d from left to right; sub-pixels of the third row of the pixel structure are, in order, sub-pixel b, sub-pixel a, sub-pixel b and sub-pixel c from left to right; sub-pixels of the fourth row of the pixel structure are, in order, sub-pixel d, sub-pixel c, sub-pixel d and sub-pixel a from left to right.

The pixel structure also can be the display unit shown in fig. 7, fig.8 or fig.9, i.e. the 2×8 sub-pixel array. The arrangement structure of the pixel structure is selected from one of the following combinations when the pixel structure is the 2×8 sub-pixel array:
sub-pixels of the first row are, in order, sub-pixel a, sub-pixel b, sub-pixel a, sub-pixel d, sub-pixel c, sub-pixel b, sub-pixel c and sub-pixel d from left to right; sub-pixels of the second row are, in order, sub-pixel c, sub-pixel d, sub-pixel c, sub-pixel b, sub-pixel a, sub-pixel d, sub-pixel a and sub-pixel b from left to right;
sub-pixels of the first row are, in order, sub-pixel b, sub-pixel a, sub-pixel b, sub-pixel a, sub-pixel d, sub-pixel c, sub-pixel d, and sub-pixel c from left to right; sub-pixels of the second row are, in order, sub-pixel d, sub-pixel c, sub-pixel d, sub-pixel c, sub-pixel b, sub-pixel a, sub-pixel b and sub-pixel a from left to right;
sub-pixels of the first row are, in order, sub-pixel b, sub-pixel a, sub-pixel b, sub-pixel a, sub-pixel b, sub-pixel c, sub-pixel b and sub-pixel c from left to right; sub-pixels of the second row are, in order, sub-pixel d, sub-pixel c, sub-pixel d, sub-pixel c, sub-pixel d, sub-pixel a, sub-pixel d and sub-pixel a from left to right;

The color of each of the sub-pixels a, b, c and d is one of red, green, blue and white. The advantages of the arrangement of the pixel structure can refer to the above description.

In summary, the present invention improves the uniformity of the spatial sampling by optimizing the arrangement structure of the sub-pixel array in the display panel and the pixel structure, so that the resolution of the display panel can be improved. Furthermore, the brightness of the display panel is improved with reduced power loss by the addition of the white sub-pixel. In addition, the sub-pixel unit aa or cc is controlled by the same drive circuit, the power loss is further reduced, and the average aperture ratio of the display panel is improved.

## Claims

1. A display panel, the display panel is formed by a repeated arrangement of a plurality of display units, each of the plurality of display units consisting of a continuous 4×4 array or a continuous 2×8 array, **characterized in that**:
sub-pixels of the first row of the display unit (21) formed by the 4×4 array are, in order, sub-pixel a, sub-pixel b, sub-pixel c and sub-pixel b from left to right; sub-pixels of the second row of the display unit formed by the 4×4 array are, in order, sub-pixel c, sub-pixel d, sub-pixel a and sub-pixel d from left to right; sub-pixels of the third row of the display unit formed by the 4×4 array are, in order, sub-pixel b, sub-pixel a, sub-pixel b and sub-pixel c from left to right; sub-pixels of the fourth row of the display unit formed by the 4×4 array are, in order, sub-pixel d, sub-pixel c, sub-pixel d and sub-pixel a from left to right;
an arrangement structure of sub-pixels of the display unit (31, 41, 51) formed by the 2×8 array is selected from one of the following combinations:
sub-pixels of the first row are, in order, sub-pixel a, sub-pixel b, sub-pixel a, sub-pixel d, sub-pixel c, sub-pixel b, sub-pixel c and sub-pixel d from left to right; sub-pixels of the second row are, in order, sub-pixel c, sub-pixel d, sub-pixel c, sub-pixel b, sub-pixel a, sub-pixel d, sub-pixel a and sub-pixel b from left to right;
sub-pixels of the first row are, in order, sub-pixel b, sub-pixel a, sub-pixel b, sub-pixel a, sub-pixel d, sub-pixel c, sub-pixel d, and sub-pixel c from left to right; sub-pixels of the second row are, in order, sub-pixel d, sub-pixel c, sub-pixel d, sub-pixel c, sub-pixel b, sub-pixel a, sub-pixel b and sub-pixel a from left to right;
sub-pixels of the first row are, in order, sub-pixel b, sub-pixel a, sub-pixel b, sub-pixel a, sub-pixel b, sub-pixel c, sub-pixel b and sub-pixel c from left to right; sub-pixels of the second row are, in order, sub-pixel d, sub-pixel c, sub-pixel d, sub-pixel c, sub-pixel d, sub-pixel a, sub-pixel d and sub-pixel a from left to right;
colors of the sub-pixels a, b, c and d are different from each other,
wherein the color of each of the sub-pixels a and c is red or blue, the color of each of the sub-pixels b and d is green or white.

2. The display panel according to claim 1, wherein the arrangement structure of the display unit (21, 22, 23) formed by the 4×4 array is one of the following combinations:
sub-pixels of the first row are, in order, R sub-pixel, G sub-pixel, B sub-pixel and G sub-pixel from left to right; sub-pixels of the second row are, in order, B sub-pixel, W sub-pixel, R sub-pixel and W sub-pixel from left to right; sub-pixels of the third row are, in order, G sub-pixel, R sub-pixel, G sub-pixel and B sub-pixel from left to right; sub-pixels of the fourth row are, in order, W sub-pixel, B sub-pixel, W sub-pixel and R sub-pixel from left to right;
sub-pixels of the first row are, in order, R sub-pixel, W sub-pixel, B sub-pixel and W sub-pixel from left to right; sub-pixels of the second row are, in order, B sub-pixel, G sub-pixel, R sub-pixel and G sub-pixel from left to right; sub-pixels of the third row are, in order, W sub-pixel, R sub-pixel, W sub-pixel and B sub-pixel from left to right; sub-pixels of the fourth row are, in order, G sub-pixel, B sub-pixel, G sub-pixel and R sub-pixel from left to right;
sub-pixels of the first row are, in order, B sub-pixel, G sub-pixel, R sub-pixel and G sub-pixel from left to right; sub-pixels of the second row are, in order, R sub-pixel, W sub-pixel, B sub-pixel and W sub-pixel from left to right; sub-pixels of the third row are, in order, G sub-pixel, B sub-pixel, G sub-pixel and R sub-pixel from left to right; sub-pixels of the fourth row are, in order, W sub-pixel, R sub-pixel, W sub-pixel and B sub-pixel from left to right;
sub-pixels of the first row are, in order, B sub-pixel, W sub-pixel, R sub-pixel and W sub-pixel from left to right; sub-pixels of the second row are, in order, R sub-pixel, G sub-pixel, B sub-pixel and G sub-pixel from left to right; sub-pixels of the third row are, in order, W sub-pixel, B sub-pixel, W sub-pixel and R sub-pixel from left to right; sub-pixels of the fourth row are, in order, G sub-pixel, R sub-pixel, G sub-pixel and B sub-pixel from left to right;
the arrangement structure of the display unit (31, 32, 33, 41, 42, 43, 51, 52, 53) formed by the 2×8 array is one of the following combinations:
sub-pixels of the first row are, in order, R sub-pixel, G sub-pixel, R sub-pixel, W sub-pixel, B sub-pixel, G sub-pixel, B sub-pixel and W sub-pixel from left to right; sub-pixels of the second row are, in order, B sub-pixel, W sub-pixel, B sub-pixel, G sub-pixel, R sub-pixel, W sub-pixel, R sub-pixel and G sub-pixel from left to right;
sub-pixels of the first row are, in order, B sub-pixel, G sub-pixel, B sub-pixel, W sub-pixel, R sub-pixel, G sub-pixel, R sub-pixel and W sub-pixel from left to right; sub-pixels of the second row are, in order, R sub-pixel, W sub-pixel, R sub-pixel, G sub-pixel, B sub-pixel, W sub-pixel, B sub-pixel and G sub-pixel from left to right;
sub-pixels of the first row are, in order, R sub-pixel, W sub-pixel, R sub-pixel, G sub-pixel, B sub-pixel, W sub-pixel, B sub-pixel and G sub-pixel from left to right; sub-pixels of the second row are, in order, B sub-pixel, G sub-pixel, B sub-pixel, W sub-pixel, R sub-pixel, G sub-pixel, R sub-pixel and W sub-pixel from left to right; sub-pixels of the first row are, in order, B sub-pixel, W sub-pixel, B sub-pixel, G sub-pixel, R sub-pixel, W sub-pixel, R sub-pixel and G sub-pixel from left to right;
sub-pixels of the second row are, in order, R sub-pixel, G sub-pixel, R sub-pixel, W sub-pixel, B sub-pixel, G sub-pixel, B sub-pixel and W sub-pixel from left to right; sub-pixels of the first row are, in order, G sub-pixel, R sub-pixel, G sub-pixel, R sub-pixel, W sub-pixel, B sub-pixel, W sub-pixel and B sub-pixel from left to right; sub-pixels of the second row are, in order, W sub-pixel, B sub-pixel, W sub-pixel, B sub-pixel, G sub-pixel, R sub-pixel, G sub-pixel and R sub-pixel from left to right;
sub-pixels of the first row are, in order, G sub-pixel, B sub-pixel, G sub-pixel, B sub-pixel, W sub-pixel, R sub-pixel, W sub-pixel and R sub-pixel from left to right; sub-pixels of the second row are, in order, W sub-pixel, R sub-pixel, W sub-pixel, R sub-pixel, G sub-pixel, B sub-pixel, G sub-pixel and B sub-pixel from left to right;
sub-pixels of the first row are, in order, W sub-pixel, R sub-pixel, W sub-pixel, R sub-pixel, G sub-pixel, B sub-pixel, G sub-pixel and B sub-pixel from left to right; sub-pixels of the second row are, in order, G sub-pixel, B sub-pixel, G sub-pixel, B sub-pixel, W sub-pixel, R sub-pixel, W sub-pixel and R sub-pixel from left to right; sub-pixels of the first row are, in order, W sub-pixel, B sub-pixel, W sub-pixel, B sub-pixel, G sub-pixel, R sub-pixel, G sub-pixel and R sub-pixel from left to right; sub-pixels of the second row are, in order, G sub-pixel, R sub-pixel, G sub-pixel, R sub-pixel, W sub-pixel, B sub-pixel, W sub-pixel and B sub-pixel from left to right; sub-pixels of the first row are, in order, G sub-pixel, R sub-pixel, G sub-pixel, R sub-pixel, G sub-pixel, B sub-pixel, G sub-pixel and B sub-pixel from left to right; sub-pixels of the second row are, in order, W sub-pixel, B sub-pixel, W sub-pixel, B sub-pixel, W sub-pixel, R sub-pixel, W sub-pixel and R sub-pixel from left to right;
sub-pixels of the first row are, in order, G sub-pixel, B sub-pixel, G sub-pixel, B sub-pixel, G sub-pixel, R sub-pixel, G sub-pixel and R sub-pixel from left to right; sub-pixels of the second row are, in order, W sub-pixel, R sub-pixel, W sub-pixel, R sub-pixel, W sub-pixel, B sub-pixel, W sub-pixel and B sub-pixel from left to right;
sub-pixels of the first row are, in order, W sub-pixel, R sub-pixel, W sub-pixel, R sub-pixel, W sub-pixel, B sub-pixel, W sub-pixel and B sub-pixel from left to right; sub-pixels of the second row are, in order, G sub-pixel, B sub-pixel, G sub-pixel, B sub-pixel, G sub-pixel, R sub-pixel, G sub-pixel and R sub-pixel from left to right; sub-pixels of the first row are, in order, W sub-pixel, B sub-pixel, W sub-pixel, B sub-pixel, W sub-pixel, R sub-pixel, W sub-pixel and R sub-pixel from left to right; sub-pixels of the second row are, in order, G sub-pixel, R sub-pixel, G sub-pixel, R sub-pixel, G sub-pixel, B sub-pixel, G sub-pixel and B sub-pixel from left to right; wherein R, G, B and W sub-pixels are a red sub-pixel, a green sub-pixel, a blue sub-pixel and a white sub-pixel, respectively.

3. The display panel according to claim 1, wherein on the display panel a sub-pixel unit aa is formed by adjacent two sub-pixels a, a sub-pixel unit cc is formed by adjacent two sub-pixels c when the display unit is the 4×4 array, wherein sub-pixels of each sub-pixel unit aa are controlled by one aa sub-pixel drive circuit, sub-pixels of each sub-pixel unit cc are controlled by one cc sub-pixel drive circuit.

4. The display panel according to claim 1, wherein an aspect ratio of each of the sub-pixels a, b, c and d is 1:2 when the display unit is the 2×8 array.

5. The display panel according to claim 1, wherein an aspect ratio of each of the sub-pixels a, b, c and d is 1:1 when the display unit is the 4×4 array.

6. The display panel according to claim 1, wherein the display panel is formed by the repeated arrangement of the rotated, transposed or reversed display units.

7. A pixel structure, wherein the pixel structure is the sub-pixel array in any continuous arrays 4×4 in the display panel formed by the 4×4 arrays according to claim 1 or the sub-pixel array in any continuous 2×8 arrays in the display panel formed by the 2×8 arrays according to claim 1.

8. The pixel structure according to claim 7, wherein sub-pixels of the first row of the pixel structure are, in order, sub-pixel a, sub-pixel b, sub-pixel c and sub-pixel b from left to right; sub-pixels of the second row of the pixel structure are, in order, sub-pixel c, sub-pixel d, sub-pixel a and sub-pixel d from left to right; sub-pixels of the third row of the pixel structure are, in order, sub-pixel b, sub-pixel a, sub-pixel b and sub-pixel c from left to right; sub-pixels of the fourth row of the pixel structure are, in order, sub-pixel d, sub-pixel c, sub-pixel d and sub-pixel a from left to right when the pixel structure is the 4×4 array;
the pixel structure is selected from one of the following combinations when the pixel structure is the 2×8 array:
sub-pixels of the first row are, in order, sub-pixel a, sub-pixel b, sub-pixel a, sub-pixel d, sub-pixel c, sub-pixel b, sub-pixel c and sub-pixel d from left to right; sub-pixels of the second row are, in order, sub-pixel c, sub-pixel d, sub-pixel c, sub-pixel b, sub-pixel a, sub-pixel d, sub-pixel a and sub-pixel b from left to right;
sub-pixels of the first row are, in order, sub-pixel b, sub-pixel a, sub-pixel b, sub-pixel a, sub-pixel d, sub-pixel c, sub-pixel d, and sub-pixel c from left to right; sub-pixels of the second row are, in order, sub-pixel d, sub-pixel c, sub-pixel d, sub-pixel c, sub-pixel b, sub-pixel a, sub-pixel b and sub-pixel a from left to right;
sub-pixels of the first row are, in order, sub-pixel b, sub-pixel a, sub-pixel b, sub-pixel a, sub-pixel b, sub-pixel c, sub-pixel b and sub-pixel c from left to right; sub-pixels f the second row are, in order, sub-pixel d, sub-pixel c, sub-pixel d, sub-pixel c, sub-pixel d, sub-pixel a, sub-pixel d and sub-pixel a from left to right.

## Patentansprüche

1. Anzeigetafel, wobei die Anzeigetafel durch eine wiederholte Anordnung von einer Mehrzahl von Anzeigeeinheiten ausgebildet ist, wobei jede von der Mehrzahl von Anzeigeeinheiten aus einem kontinuierlichen 4x4-Feld oder einem kontinuierlichen 2x8-Feld besteht, **dadurch gekennzeichnet, dass**:
Subpixel der ersten Reihe der Anzeigeeinheit (21), die durch das 4x4-Feld gebildet ist, in dieser Reihenfolge, ein Subpixel a, ein Subpixel b, ein Subpixel c und ein Subpixel b von links nach rechts sind; Subpixel der zweiten Reihe der Anzeigeeinheit, die durch das 4x4-Feld gebildet ist, in dieser Reihenfolge, das Subpixel c, das Subpixel d, das Subpixel a und das Subpixel d von links nach rechts sind; Subpixel der dritten Reihe der Anzeigeeinheit, die durch das 4x4-Feld gebildet ist, in dieser Reihenfolge, das Subpixel b, das Subpixel a, das Subpixel b und das Subpixel c von links nach rechts sind; Subpixel der vierten Reihe der Anzeigeeinheit, die durch das 4x4-Feld gebildet ist, in dieser Reihenfolge, das Subpixel d, das Subpixel c, das Subpixel d und das Subpixel a von links nach rechts sind;
eine Anordnungsstruktur der Subpixel der Anzeigeeinheit (31, 41, 51), die durch das 2x8-Feld gebildet ist, ausgewählt ist aus einer der nachstehenden Kombinationen:
Subpixel der ersten Reihe sind, in dieser Reihenfolge, das Subpixel a, das Subpixel b, das Subpixel a, das Subpixel d, das Subpixel c, das Subpixel b, das Subpixel c und das Subpixel d von links nach rechts; Subpixel der zweiten Reihe sind, in dieser Reihenfolge, das Subpixel c, das Subpixel d, das Subpixel c, das Subpixel b, das Subpixel a, das Subpixel d, das Subpixel a und das Subpixel b von links nach rechts;
Subpixel der ersten Reihe sind, in dieser Reihenfolge, das Subpixel b, das Subpixel a, das Subpixel b, das Subpixel a, das Subpixel d, das Subpixel c, das Subpixel d und das Subpixel c von links nach rechts; Subpixel der zweiten Reihe sind, in dieser Reihenfolge, das Subpixel d, das Subpixel c, das Subpixel d, das Subpixel c, das Subpixel b, das Subpixel a, das Subpixel b und das Subpixel a von links nach rechts;
Subpixel der ersten Reihe sind, in dieser Reihenfolge, das Subpixel b, das Subpixel a, das Subpixel b, das Subpixel a, das Subpixel b, das Subpixel c, das Subpixel b und das Subpixel c von links nach rechts; Subpixel der zweiten Reihe sind, in dieser Reihenfolge, das Subpixel d, das Subpixel c, das Subpixel d, das Subpixel c, das Subpixel d, das Subpixel a, das Subpixel d, und das Subpixel a von links nach rechts,
Farben der Subpixel a, b, c und d sich voneinander unterscheiden,
wobei die Farbe von jedem von der Subpixeln a und c rot oder blau ist, die Farbe von jedem der Subpixel b und d grün oder weiß ist.

2. Anzeigetafel nach Anspruch 1, wobei die Anordnungsstruktur der Anzeigeeinheit (21, 22, 23), die durch das 4x4-Feld gebildet ist, eine der folgenden Kombinationen ist:
Subpixel der ersten Reihe sind, in dieser Reihenfolge, R-Subpixel, G-Subpixel, B-Subpixel und G-Subpixel von links nach rechts, Subpixel der zweiten Reihe sind, in dieser Reihenfolge, B-Subpixel, W-Subpixel, R-Subpixel und W-Subpixel von links nach rechts; Subpixel der dritten Reihe sind, in dieser Reihenfolge, G-Subpixel, R-Subpixel, G-Subpixel und B-Subpixel von links nach rechts; Subpixel der der vierten Reihe sind, in dieser Reihenfolge, W-Subpixel, B-Subpixel, W-Subpixel und R-Subpixel von links nach rechts;
Subpixel der ersten Reihe sind, in dieser Reihenfolge, R-Subpixel, W-Subpixel, B-Subpixel und W-Subpixel von links nach rechts; Subpixel der zweiten Reihe, sind in dieser Reihenfolge, B-Subpixel, G-Subpixel, R-Subpixel und G-Subpixel von links nach rechts; Subpixel der dritten Reihe sind, in dieser Reihenfolge, W-Subpixel, R-Subpixel, W-Subpixel und B-Subpixel von links nach rechts; Subpixel der vierten Reihe sind, in dieser Reihenfolge G-Subpixel, B-Subpixel, G-Subpixel und R-Subpixel von links nach rechts;
Subpixel der ersten Reihe sind, in dieser Reihenfolge, B-Subpixel, G-Subpixel, R-Subpixel und G-Subpixel von links nach rechts; Subpixel der zweiten Reihe sind, in dieser Reihenfolge, R-Subpixel, W-Subpixel, B-Subpixel und W-Subpixel von links nach rechts; Subpixel der dritten Reihe sind, in dieser Reihenfolge, G-Subpixel, B-Subpixel, G-Subpixel und R-Subpixel von links nach rechts; Subpixel der vierten Reihe sind, in dieser Reihenfolge, W-Subpixel, R-Subpixel, W-Subpixel und B-Subpixel von links nach rechts;
Subpixel der ersten Reihe sind, in dieser Reihenfolge, B-Subpixel, W-Subpixel, R-Subpixel und W-Subpixel von links nach rechts; Subpixel der zweiten Reihe sind, in dieser Reihenfolge, R-Subpixel, G-Subpixel, B-Subpixel und G-Subpixel von links nach rechts; Subpixel der dritten Reihe sind, in dieser Reihenfolge, W-Subpixel, B-Subpixel, W-Subpixel und R-Subpixel von links nach rechts; Subpixel der vierten Reihe sind, in dieser Reihenfolge, G-Subpixel, R-Subpixel, G-Subpixel und B-Subpixel von links nach rechts;
wobei die Anordnungsstruktur der Anzeigeeinheit (31, 32, 33, 41, 42, 43, 51, 52, 53), die durch das 2x8-Feld gebildet ist, eine der folgenden Kombinationen ist:
Subpixel der ersten Reihe sind, in dieser Reihenfolge, R-Subpixel, G-Subpixel, R-Subpixel, W-Subpixel, B-Subpixel, G-Subpixel, B-Subpixel und W-Subpixel von links nach rechts; Subpixel der zweiten Reihe sind, in dieser Reihenfolge, B-Subpixel, W-Subpixel, B-Subpixel, G-Subpixel, R-Subpixel, W-Subpixel, R-Subpixel, und G-Subpixel von links nach rechts;
Subpixel von erste Reihe sind, in dieser Reihenfolge, B-Subpixel, G-Subpixel, B-Subpixel, W-Subpixel, R-Subpixel, G-Subpixel, R-Subpixel und W-Subpixel von links nach rechts; Subpixel der zweiten Reihe sind, in dieser Reihenfolge, R-Subpixel, W-Subpixel, R-Subpixel, G-Subpixel, B-Subpixel, W-Subpixel, B-Subpixel und G-Subpixel von links nach rechts;
Subpixel der ersten Reihe sind, in dieser Reihenfolge, R-Subpixel, W-Subpixel, R-Subpixel, G-Subpixel, B-Subpixel, W-Subpixel, B-Subpixel und G-Subpixel von links nach rechts; Subpixel der zweiten Reihe sind, in dieser Reihenfolge, B-Subpixel, G-Subpixel, B-Subpixel, W-Subpixel, R-Subpixel, G-Subpixel, R-Subpixel, und W-Subpixel von links nach rechts; Subpixel der ersten Reihe sind, in dieser Reihenfolge, B-Subpixel, W-Subpixel, B-Subpixel, G-Subpixel, R-Subpixel, W-Subpixel, R-Subpixel und G-Subpixel von links nach rechts; Subpixel der zweiten Reihe sind, in dieser Reihenfolge, R-Subpixel, G-Subpixel, R-Subpixel, W-Subpixel, B-Subpixel, G-Subpixel, B-Subpixel, und W-Subpixel von links nach rechts; Subpixel der ersten Reihe sind in dieser Reihenfolge, G-Subpixel, R-Subpixel, G-Subpixel, R-Subpixel, W-Subpixel, B-Subpixel und W-Subpixel und B-Subpixel von links nach rechts; Subpixel der zweiten Reihe sind, in dieser Reihenfolge, W-Subpixel, B-Subpixel, W-Subpixel, B-Subpixel, G-Subpixel, R-Subpixel, G-Subpixel und R-Subpixel von links nach rechts;
Subpixel der ersten Reihe sind, in dieser Reihenfolge, G-Subpixel, B-Subpixel, G-Subpixel, B-Subpixel, W-Subpixel, R-Subpixel, W-Subpixel und R-Subpixel von links nach rechts; Subpixel der zweiten Reihe sind, in dieser Reihenfolge, W-Subpixel, R-Subpixel, W-Subpixel, R-Subpixel, G-Subpixel, B-Subpixel, G-Subpixel und R-Subpixel von links nach rechts;
Subpixel der ersten Reihe sind, in dieser Reihenfolge, W-Subpixel, R-Subpixel, W-Subpixel, R-Subpixel, G-Subpixel, B-Subpixel, G-Subpixel und B-Subpixel von links nach rechts; Subpixel der zweiten Reihe sind, in dieser Reihenfolge, G-Subpixel, B-Subpixel, G-Subpixel, B-Subpixel, W-Subpixel, R-Subpixel, W-Subpixel und R-Subpixel von links nach rechts; Subpixel der ersten Reihe sind, in dieser Reihenfolge, W-Subpixel, B-Subpixel, W-Subpixel, B-Subpixel, G-Subpixel, R-Subpixel, G-Subpixel und R-Subpixel von links nach rechts; Subpixel der zweiten Reihe sind, in dieser Reihenfolge, G-Subpixel, R-Subpixel, G-Subpixel, R-Subpixel, W-Subpixel, B-Subpixel, W-Subpixel und B-Subpixel von links nach rechts; Subpixel der ersten Reihe sind, in dieser Reihenfolge, G-Subpixel, R-Subpixel, G-Subpixel, R-Subpixel, G-Subpixel, B-Subpixel, G-Subpixel und B-Subpixel von links nach rechts; Subpixel der zweiten Reihe sind, in dieser Reihenfolge, W-Subpixel, B-Subpixel, W-Subpixel, B-Subpixel, W-Subpixel, R-Subpixel, W-Subpixel und R-Subpixel von links nach rechts; Subpixel der ersten Reihe sind, in dieser Reihenfolge, G-Subpixel, B-Subpixel, G-Subpixel, B-Subpixel, G-Subpixel, R-Subpixel, G-Subpixel und R-Subpixel von links nach rechts; Subpixel der zweiten Reihe sind, in dieser Reihenfolge, W-Subpixel, R-Subpixel, W-Subpixel, R-Subpixel, W-Subpixel, B-Subpixel, W-Subpixel und R-Subpixel von links nach rechts;
Subpixel der ersten Reihe sind, in dieser Reihenfolge, W-Subpixel, R-Subpixel, W-Subpixel, R-Subpixel, W-Subpixel, B-Subpixel, W-Subpixel und B-Subpixel von links nach rechts; Subpixel der zweiten Reihe sind, in dieser Reihenfolge, G-Subpixel, B-Subpixel, G-Subpixel, B-Subpixel, G-Subpixel, R-Subpixel, G-Subpixel und R-Subpixel von links nach rechts; Subpixel der ersten Reihe sind, in dieser Reihenfolge, W-Subpixel, B-Subpixel, W-Subpixel, B-Subpixel, W-Subpixel, R-Subpixel, W-Subpixel und R-Subpixel von links nach rechts; Subpixel der zweiten Reihe sind, in dieser Reihenfolge, G-Subpixel, R-Subpixel, G-Subpixel, R-Subpixel, G-Subpixel, B-Subpixel, G-Subpixel und B-Subpixel von links nach rechts; wobei die R-, G-, B- und W-Subpixel ein rotes Subpixel, ein grünes Subpixel, ein blaues Subpixel beziehungsweiße ein weißes Subpixel sind;

3. Anzeigetafel nach Anspruch 1, wobei
auf der Anzeigetafel eine Subpixeleinheit aa ausgebildet ist durch zwei benachbarte Subpixel a, eine Subpixeleinheit cc ausgebildet ist durch zwei benachbarte Subpixel c, wenn die Anzeigeeinheit das 4x4-Feld ist, wobei Subpixel von jeder Subpixeleinheit aa gesteuert werden durch eine aa-Subpixel-Antriebsschaltung, Subpixel von jeder Subpixeleinheit cc gesteuert werden durch eine cc Subpixel-Antriebsschaltung.

4. Anzeigetafel nach Anspruch 1, wobei
ein Aspektverhältnis von jedem der Subpixel a, b, c und d 1:2 ist, wenn die Anzeigeeinheit das 2x8-Feld ist.

5. Anzeigetafel nach Anspruch 1, wobei ein Aspektverhältnis von jedem der Subpixel a, b, c und d 1:1 ist, wenn die Anzeigeeinheit das 4x4-Feld ist.

6. Anzeigetafel nach Anspruch 1, wobei die Anzeigetafel ausgebildet ist durch die wiederholte Anordnung der rotierten, vertauschten oder umgekehrten Anzeigeeinheiten.

7. Pixelstruktur, wobei
die Pixelstruktur das Subpixelfeld in beliebigen kontinuierlichen 4x4-Feldern in der Anzeigetafel ist, die durch die 4x4-Felder nach Anspruch 1 gebildet ist, oder das Subpixelfeld in beliebigen kontinuierlichen 2x8-Feldern in der Anzeigetafel ist, die durch die 2x8-Felder nach Anspruch 1 gebildet ist.

8. Pixelstruktur nach Anspruch 7, wobei Subpixel der ersten Reihe der Pixelstruktur, in dieser Reihenfolge, ein Subpixel a, ein Subpixel b, ein Subpixel c und ein Subpixel b von links nach rechts sind; Subpixel der zweiten Reihe der Pixelstruktur, in dieser Reihenfolge, Subpixel c, Subpixel d, Subpixel a und Subpixel d von links nach rechts sind; Subpixel der dritten Reihe der Pixelstruktur, in dieser Reihenfolge, Subpixel b, Subpixel a, Subpixel c von links nach rechts sind; Subpixel der vierten Reihe der Pixelstruktur, in dieser Reihenfolge, Subpixel d, Subpixel c, Subpixel d und Subpixel a von links nach rechts sind, wenn die Pixelstruktur das 4x4-Feld ist;
die Pixelstruktur ausgewählt ist aus einer der nachstehenden Kombinationen, wenn die Pixelstruktur das 2x8-Feld ist:
Subpixel der ersten Reihe, in dieser Reihenfolge, das Subpixel a, das Subpixel b, das Subpixel a, das Subpixel d, das Subpixel c, das Subpixel b, das Subpixel c und das Subpixel d von links nach rechts sind; Subpixel der zweiten Reihe, in dieser Reihenfolge, das Subpixel c, das Subpixel d, das Subpixel c, das Subpixel b, das Subpixel a, das Subpixel d, das Subpixel a und das Subpixel b von links nach rechts sind;
Subpixel der ersten Reihe, in dieser Reihenfolge, das Subpixel b, das Subpixel a, das Subpixel b, das Subpixel a, das Subpixel d, das Subpixel c, das Subpixel d und das Subpixel c von links nach rechts sind, Subpixel der zweiten Reihe, in dieser Reihenfolge, das Subpixel d, das Subpixel c, das Subpixel d, das Subpixel c, das Subpixel b, das Subpixel b und das Subpixel a von links nach rechts sind;
Subpixel der ersten Reihe, in dieser Reihenfolge, das Subpixel b, das Subpixel a, das Subpixel b, das Subpixel a, das Subpixel b, das Subpixel c, das Subpixel b und das Subpixel c von links nach rechts sind, Subpixel der der zweiten Reihe, in dieser Reihenfolge, das Subpixel d, das Subpixel c, das Subpixel d, das Subpixel c, das Subpixel d, das Subpixel a, das Subpixel d und das Subpixel a von links nach rechts sind.

## Revendications

1. Panneau d'affichage, le panneau d'affichage est formé par un agencement répété d'une pluralité d'unités d'affichage, chacune de la pluralité d'unités d'affichage consistant en une matrice 4x4 continu ou une matrice 2x8 continu, **caractérisé en ce que** :
les sous-pixels de la première rangée de l'unité d'affichage (21) formée par la matrice 4x4 sont, dans l'ordre, le sous-pixel a, sous-pixel b, sous-pixel c et sous-pixel b de gauche à droite ;
les sous-pixels de la deuxième rangée de l'unité d'affichage formée par la matrice 4x4 sont, dans l'ordre, le sous-pixel c, sous-pixel d, sous-pixel a et sous-pixel d de gauche à droite ; les sous-pixels de la troisième rangée de l'unité d'affichage formée par la matrice 4x4 sont, dans l'ordre, le sous-pixel b, sous-pixel a, sous-pixel b et sous-pixel c de gauche à droite ; les sous-pixels de la quatrième rangée de l'unité d'affichage formée par la matrice 4x4 sont, dans l'ordre, le sous-pixel d, sous-pixel c, sous-pixel d et sous-pixel a de gauche à droite ;
une structure d'agencement de sous-pixels de l'unité d'affichage (31, 41, 51) formée par la matrice 2X8 est sélectionnée parmi l'une des combinaisons suivantes :
les sous-pixels de la première rangée sont, dans l'ordre, le sous-pixel a, sous-pixel b, sous-pixel a, sous-pixel d, sous-pixel c, sous-pixel b, sous-pixel c et sous-pixel d de gauche à droite ; les sous-pixels de la deuxième rangée sont, dans l'ordre, le sous-pixel c, sous-pixel d, sous-pixel c, sous-pixel b, sous-pixel a, sous-pixel d, sous-pixel a et sous-pixel b de gauche à droite ;
les sous-pixels de la première rangée sont, dans l'ordre, le sous-pixel b, sous-pixel a, sous-pixel b, sous-pixel a, sous-pixel d, sous-pixel c, sous-pixel d et sous-pixel c de gauche à droite ; les sous-pixels de la deuxième rangée sont, dans l'ordre, le sous-pixel d, sous-pixel c, sous-pixel d, sous-pixel c, sous-pixel b, sous-pixel a, sous-pixel b et sous-pixel a de gauche à droite ;
les sous-pixels de la première rangée sont, dans l'ordre, le sous-pixel b, sous-pixel a, sous-pixel b, sous-pixel a, sous-pixel b, sous-pixel c, sous-pixel b et sous-pixel c de gauche à droite ; les sous-pixels de la deuxième rangée sont, dans l'ordre, le sous-pixel d, sous-pixel c, sous-pixel d, sous-pixel c, sous-pixel d, sous-pixel a, sous-pixel d et sous-pixel a de gauche à droite ; les couleurs des sous-pixels a, b, c et d sont différentes l'une de l'autre,
dans lequel la couleur de chacun des sous-pixels a et c est rouge ou bleue, la couleur de chacun des sous-pixels b et d est verte ou blanche.

2. Panneau d'affichage selon la revendication 1, dans lequel la structure d'agencement de l'unité d'affichage (21, 22, 23) formée par le groupement 4x4 est l'une des combinaisons suivantes :
les sous-pixels de la première rangée sont, dans l'ordre, le R sous-pixel, G sous-pixel, B sous-pixel et G sous-pixel de gauche à droite ; les sous-pixels de la deuxième rangée sont, dans l'ordre, le B sous-pixel, W sous-pixel, R sous-pixel et W sous-pixel de gauche à droite ; les sous-pixels de la troisième rangée sont, dans l'ordre, le G sous-pixel, R sous-pixel, G sous-pixel et B sous-pixel de gauche à droite ; les sous-pixels de la quatrième rangée sont, dans l'ordre, le W sous-pixel, B sous-pixel, W sous-pixel et R sous-pixel de gauche à droite ;
les sous-pixels de la première rangée sont, dans l'ordre, le R sous-pixel, W sous-pixel, B sous-pixel et W sous-pixel de gauche à droite ; les sous-pixels de la deuxième rangée sont, dans l'ordre, le B sous-pixel, G sous-pixel, R sous-pixel et G sous-pixel de gauche à droite ; les sous-pixels de la troisième rangée sont, dans l'ordre, le W sous-pixel, R sous-pixel, W sous-pixel et B sous-pixel de gauche à droite ; les sous-pixels de la quatrième rangée sont, dans l'ordre, le G sous-pixel, B sous-pixel, G sous-pixel et R sous-pixel de gauche à droite ;
les sous-pixels de la première rangée sont, dans l'ordre, le B sous-pixel, G sous-pixel, R sous-pixel et G sous-pixel de gauche à droite ; les sous-pixels de la deuxième rangée sont, dans l'ordre, le R sous-pixel, W sous-pixel, B sous-pixel et W sous-pixel de gauche à droite ; les sous-pixels de la troisième rangée sont, dans l'ordre, le G sous-pixel, B sous-pixel, G sous-pixel et R sous-pixel de gauche à droite ; les sous-pixels de la quatrième rangée sont, dans l'ordre, le W sous-pixel, R sous-pixel, W sous-pixel et B sous-pixel de gauche à droite ;
les sous-pixels de la première rangée sont, dans l'ordre, le B sous-pixel, W sous-pixel, R sous-pixel et W sous-pixel de gauche à droite ; les sous-pixels de la deuxième rangée sont, dans l'ordre, le R sous-pixel, G sous-pixel, B sous-pixel et G sous-pixel de gauche à droite ; les sous-pixels de la troisième rangée sont, dans l'ordre, le W sous-pixel, B sous-pixel, W sous-pixel et R sous-pixel de gauche à droite ; les sous-pixels de la quatrième rangée sont, dans l'ordre, le G sous-pixel, R sous-pixel, G sous-pixel et B sous-pixel de gauche à droite ;
la structure d'agencement de l'unité d'affichage (31, 32, 33, 41, 42, 43, 51, 52, 53) formée par le groupement 2x8 est l'une des combinaisons suivantes :
les sous-pixels de la première rangée sont, dans l'ordre, le R sous-pixel, G sous-pixel, R sous-pixel, W sous-pixel, B sous-pixel, G sous-pixel, B sous-pixel et W sous-pixel de gauche à droite ; les sous-pixels de la deuxième rangée sont, dans l'ordre, le B sous-pixel, W sous-pixel, B sous-pixel, G sous-pixel, R sous-pixel, W sous-pixel, R sous-pixel et G sous-pixel de gauche à droite ;
les sous-pixels de la première rangée sont, dans l'ordre, le B sous-pixel, G sous-pixel, B sous-pixel, W sous-pixel, R sous-pixel, G sous-pixel, R sous-pixel et W sous-pixel de gauche à droite ; les sous-pixels de la deuxième rangée sont, dans l'ordre, le R sous-pixel, W sous-pixel, R sous-pixel, G sous-pixel, B sous-pixel, W sous-pixel, B sous-pixel et G sous-pixel pixel de gauche à droite ;
les sous-pixels de la première rangée sont, dans l'ordre, le R sous-pixel, W sous-pixel, R sous-pixel, G sous-pixel, B sous-pixel, W sous-pixel, B sous-pixel et G sous-pixel de gauche à droite ;
les sous-pixels de la deuxième rangée sont, dans l'ordre, le B sous-pixel, G sous-pixel, B sous-pixel, W sous-pixel, R sous-pixel, G sous-pixel, R sous-pixel et W sous-pixel de gauche à droite ;
les sous-pixels de la première rangée sont, dans l'ordre, le B sous-pixel, W sous-pixel, B sous-pixel, G sous-pixel, R sous-pixel, W sous-pixel, R sous-pixel et G sous-pixel de gauche à droite ;
les sous-pixels de la deuxième rangée sont, dans l'ordre, le R sous-pixel, G sous-pixel, R sous-pixel, W sous-pixel, B sous-pixel, G sous-pixel, B sous-pixel et W sous-pixel de gauche à droite ;
les sous-pixels de la première rangée sont, dans l'ordre, le G sous-pixel, R sous-pixel, G sous-pixel, R sous-pixel, W sous-pixel, B sous-pixel, W sous-pixel et B sous-pixel de gauche à droite ;
les sous-pixels de la deuxième rangée sont, dans l'ordre, le W sous-pixel, B sous-pixel, W sous-pixel, B sous-pixel, G sous-pixel, R sous-pixel, G sous-pixel et R sous-pixel de gauche à droite ;
les sous-pixels de la première rangée sont, dans l'ordre, le G sous-pixel, B sous-pixel, G sous-pixel, B sous-pixel, W sous-pixel, R sous-pixel, W sous-pixel et R sous-pixel de gauche à droite ;
les sous-pixels de la deuxième rangée sont, dans l'ordre, le W sous-pixel, R sous-pixel, W sous-pixel, R sous-pixel, G sous-pixel, B sous-pixel, G sous-pixel et B sous-pixel pixel de gauche à droite ;
les sous-pixels de la première rangée sont, dans l'ordre, le W sous-pixel, R sous-pixel, W sous-pixel, R sous-pixel, G sous-pixel, B sous-pixel, G sous-pixel et B sous-pixel de gauche à droite ;
les sous-pixels de la deuxième rangée sont, dans l'ordre, le G sous-pixel, B sous-pixel, G sous-pixel, B sous-pixel, W sous-pixel, R sous-pixel, W sous-pixel et R sous-pixel de gauche à droite ; les sous-pixels de la première rangée sont, dans l'ordre, le W sous-pixel, B sous-pixel, W sous-pixel, B sous-pixel, G sous-pixel, R sous-pixel, G sous-pixel et R sous-pixel de gauche à droite ;
les sous-pixels de la deuxième rangée sont, dans l'ordre, le G sous-pixel, R sous-pixels, G sous-pixels, R sous-pixels, W sous-pixels, B sous-pixels, W sous-pixels et B sous-pixels de gauche à droite ;
les sous-pixels de la première rangée sont, dans l'ordre, le G sous-pixel, R sous-pixel, G sous-pixel, R sous-pixel, G sous-pixel, B sous-pixel, G sous-pixel et B sous-pixel de gauche à droite ;
les sous-pixels de la deuxième rangée sont, dans l'ordre, le W sous-pixel, B sous-pixel, W sous-pixel, B sous-pixel, W sous-pixel, R sous-pixel, W sous-pixel et R sous-pixel de gauche à droite ;
les sous-pixels de la première rangée sont, dans l'ordre, le G sous-pixel, B sous-pixel, G sous-pixel, B sous-pixel, G sous-pixel, R sous-pixel, G sous-pixel et R sous-pixel de gauche à droite ;
les sous-pixels de la deuxième rangée sont, dans l'ordre, le W sous-pixel, R sous-pixel, W sous-pixel, R sous-pixel, W sous-pixel, B sous-pixel, W sous-pixel et B sous-pixel de gauche à droite ;
les sous-pixels de la première rangée sont, dans l'ordre, le W sous-pixel, R sous-pixel, W sous-pixel, R sous-pixel, W sous-pixel, B sous-pixel, W sous-pixel et B sous-pixel de gauche à droite ;
les sous-pixels de la deuxième rangée sont, dans l'ordre, le G sous-pixel, B sous-pixel, G sous-pixel, B sous-pixel, G sous-pixel, R sous-pixel, G sous-pixel et R sous-pixel de gauche à droite ;
les sous-pixels de la première rangée sont, dans l'ordre, le W sous-pixel, B sous-pixel, W sous-pixel, B sous-pixel, W sous-pixel, R sous-pixel, W sous-pixel et R sous-pixel de gauche à droite ;
les sous-pixels de la deuxième rangée sont, dans l'ordre, le G sous-pixel, R sous-pixel, G sous-pixel, R sous-pixel, G sous-pixel, B sous-pixel, G sous-pixel et B sous-pixel de gauche à droite ;
dans lesquels les sous-pixels R, V, B et W sont respectivement un sous-pixel rouge, un sous-pixel vert, un sous-pixel bleu et un sous-pixel blanc.

3. Panneau d'affichage selon la revendication 1, dans lequel une unité de sous-pixel aa est formée sur le panneau d'affichage par deux sous-pixels adjacents a, une unité de sous-pixel cc est formée par deux sous-pixels c adjacents lorsque l'unité d'affichage est la matrice 4x4, dans lequel les sous-pixels de chaque unité de sous-pixel aa sont contrôlés par un circuit de commande de sous-pixel aa, les sous-pixels de chaque unité de sous-pixel cc sont contrôlés par un circuit de commande de sous-pixel cc.

4. Panneau d'affichage selon la revendication 1, dans lequel le rapport de format de chacun des sous-pixels a, b, c et d est égal à 1 : 2 lorsque l'unité d'affichage est la matrice 2x8.

5. Panneau d'affichage selon la revendication 1, dans lequel le rapport de format de chacun des sous-pixels a, b, c et d est égal à 1 : 1 lorsque l'unité d'affichage est la matrice 4x4.

6. Panneau d'affichage selon la revendication 1, dans lequel le panneau d'affichage est formé par l'agencement répété des unités d'affichage tournées, transposées ou inversées.

7. Structure de pixels, dans laquelle la structure de pixels est la matrice de sous-pixels dans n'importe quelle matrice continue 4x4 dans le panneau d'affichage formé par les matrices 4x4 selon la revendication 1 ou la matrice de sous-pixel dans n'importe quelle matrice continue 2x8 dans le panneau d'affichage formé par les matrices 2x8 selon la revendication 1.

8. Structure de pixels selon la revendication 7, dans laquelle les sous-pixels de la première rangée de la structure de pixels sont, dans l'ordre, le sous-pixel a, sous-pixel b, sous-pixel c et sous-pixel b de gauche à droite ; les sous-pixels de la deuxième rangée de la structure de pixels sont, dans l'ordre, le sous-pixel c, sous-pixel d, sous-pixel a et sous-pixel d de gauche à droite ; les sous-pixels de la troisième rangée de la structure de pixels sont, dans l'ordre, le sous-pixel b, sous-pixel a, sous-pixel b et sous-pixel c de gauche à droite ; les sous-pixels de la quatrième rangée de la structure de pixels sont, dans l'ordre, le sous-pixel d, sous-pixel c, sous-pixel d et sous-pixel a de gauche à droite lorsque la structure de pixels est la matrice 4x4 ;
la structure de pixels est sélectionnée parmi l'une des combinaisons suivantes lorsque la structure de pixels est la matrice 2x8 :
les sous-pixels de la première rangée sont, dans l'ordre, le sous-pixel a, sous-pixel b, sous-pixel a, sous-pixel d, sous-pixel c, sous-pixel b, sous-pixel c et sous-pixel d de gauche à droite ;
les sous-pixels de la deuxième rangée sont, dans l'ordre, le sous-pixel c, sous-pixel d, sous-pixel c, sous-pixel b, sous-pixel a, sous-pixel d, sous-pixel a et sous-pixel b de gauche à droite ; le sous-pixels de la première rangée sont, dans l'ordre, le sous-pixel b, sous-pixel a, sous-pixel b, sous-pixel a, sous-pixel d, sous-pixel c, sous-pixel d et sous-pixel c de gauche à droite ; les sous-pixels de la deuxième rangée sont, dans l'ordre, le sous-pixel d, sous-pixel c, sous-pixel d, sous-pixel c, sous-pixel b, sous-pixel a, sous-pixel b et sous-pixel a de gauche à droite ;
les sous-pixels de la première rangée sont, dans l'ordre, le sous-pixel b, sous-pixel a, sous-pixel b, sous-pixel a, sous-pixel b, sous-pixel c, sous-pixel b et sous-pixel c de gauche à droite ; les sous-pixel f de la deuxième rangée sont, dans l'ordre, le sous-pixel d, sous-pixel c, sous-pixel d, sous-pixel c, sous-pixel d, sous-pixel a, sous-pixel d et sous-pixel a de gauche à droite.
